# EUROPÄISCHE PATENTSCHRIFT

(11) **EP 1 053 425 B1**
(45) Veröffentlichungstag und Bekanntmachung des Hinweises auf die Patenterteilung: **17.03.2004**
(21) Anmeldenummer: 99963205.2
(22) Anmeldetag: 05.11.1999
(51) Int. Cl.: F16K 31/00

(54) **PIEZOELEKTRISCHER ANTRIEB**
PIEZOELECTRIC DRIVE
COMMANDE PIEZOELECTRIQUE

(30) Priorität: 05.12.1998 DE 19856185
(43) Veröffentlichungstag der Anmeldung: 22.11.2000
(73) Patentinhaber: ROBERT BOSCH GMBH, 70442 Stuttgart (DE)
(72) Erfinder: HEINZ, Rudolf, D-71272 Renningen (DE); SCHMOLL, Klaus-Peter, D-74251 Lehrensteinsfeld (DE)
(86) Internationale Anmeldenummer: PCT/DE1999/003532
(87) Internationale Veröffentlichungsnummer: WO 2000/034701

(56) Entgegenhaltungen:
- EP-A- 0 844 678
- DE-A- 19 650 900
- DE-C- 19 626 671
- US-A- 5 148 077
- PATENT ABSTRACTS OF JAPAN vol. 1996, no. 08, 30. August 1996 (1996-08-30) & JP 08 097479 A (TOYOTA CENTRAL RES &DEV LAB INC), 12. April 1996 (1996-04-12)

## Beschreibung

Die Erfindung geht aus von einem piezoelektrischen Aktor nach dem Oberbegriff des Anspruchs 1. Ein derartiger piezoelektrischer Aktor ist aus der US 5, 148, 077 bekannt.

Wie allgemein bekannt, können piezoelektrische Aktoren zum Beispiel für Einspritzventile eines Kraftfahrzeugmotors sowie in Bremssystemen mit Antiblockiersystem und Antischlupfregelungen eingesetzt werden

Derartige mit piezoelektrischen Aktoren ausgestattete Einspritzventile besitzen eine durch ein stößelartiges Verschlußorgan gesteuerte Einspritzdüse. Am Stößel ist eine düsenseitige Wirkfläche angeordnet, die vom Druck des der Düse zugeführten Kraftstoffs beaufschlagt wird, wobei die Druckkräfte den Stößel in Öffnungsrichtung des Verschlußorganes zu drängen suchen. Der Stößel ragt mit einem plungerartigen Ende, dessen Querschnitt größer ist als die vorgenannte Wirkfläche, in eine Steuerkammer hinein. Der dort wirksame Druck sucht den Stößel in Schließrichtung des Verschlußorganes zu bewegen. Die Steuerkammer ist über eine Eingangsdrossel mit der unter hohem Druck stehenden Kraftstoffzufuhr und über ein in der Regel gedrosseltes bzw. mit einer Ausgangsdrossel kombiniertes Auslassventil mit einer nur geringen Druck aufweisenden Kraftstoffrückführleitung verbunden.
Bei geschlossenem Auslassventil steht in der Steuerkammer ein hoher Druck an, durch den der Stößel gegen den Druck an seiner düsenseitigen Wirkfläche in Schließrichtung des Verschlußorganes bewegt bzw. in Verschlußstellung gehalten wird. Beim Öffnen des Auslaßventiles fällt der Druck in der Steuerkammer ab, wobei das Maß des Druckabfalles durch die Bemessung der Eingangsdrossel und des Drosselwiderstandes des geöffneten Ausgangsventiles bzw. der damit kombinierten Ausgangsdrossel bestimmt wird. Im Ergebnis vermindert sich der Druck in der Steuerkammer bei geöffnetem Auslaßventil derart, daß der Stößel aufgrund der an seiner düsenseitigen Wirkfläche wirksamen Druckkräfte in Öffnungsrichtung des Verschlußorgans bewegt bzw. in Offenstellung gehalten wird.

Im Vergleich mit elektromagnetisch betätigten Einspritzventilen können piezoelektrische Aktoren schneller schalten. Allerdings muß beim Aufbau eines piezoelektrischen Aktors beachtet werden, daß durch innere Verluste im piezoelektrischen Körper des Aktors Verlustwärme entsteht, die abgeführt werden muß, damit sich der Aktor nicht überhitzt. Da die Keramikmaterialien der Piezokeramik eine schlechte Wärmeleitfähigkeit haben, ist besonders bei langen Aktoren, deren Länge größer ist als ihre Breite, die Ableitung innerhalb des im wesentlichen aus Keramikmaterial bestehenden Aktorkörpers ungünstig.

Durch die im aktiven Teil des Aktorkörpers liegenden Elektroden ist dessen Wärmeleitfähigkeit quer zu den Elektrodenschichten um den Faktor 3 bis 5 höher als senkrecht dazu, da das piezoelektrische Keramikmaterial ein schlechter Wärmeleiter ist. Dieser Faktor hängt natürlich von den geometrischen Verhältnissen, wie der Dicke der Keramikschichten, der Dicke der Elektrodenschichten vom Rand des Aktorkörpers ab. Da die Wärmeleitung, wie erwähnt, senkrecht zu den Elektrodenschichten schlecht ist, nimmt die Wärme den Weg durch die Elektroden des aktiven Teils des Aktorkörpers zu den außenliegenden gemeinsamen Elektrodenanschlüssen. Da diese außenliegenden gemeinsamen Elektrodenanschlüsse keinen Kontakt zum metallischen Aktorfuß sowie zur metallischen Halteplatte im Bereich des Aktorkopfs haben dürfen, kann auch die im Aktorkörper entstehende Wärme nicht ohne weitere Maßnahmen zu diesen metallischen Körpern abgeleitet werden. Insbesondere bedarf es wegen der an den gemeinsamen Elektrodenanschlüssen liegende hohe Spannung von ca. 200 Volt besonderer Maßnahmen zur Isolation der gemeinsamen Elektrodenanschlüsse gegenüber den metallischen Teilen des Aktormoduls.

Eine theoretisch mögliche Kühlung des Aktors mit einem flüssigen Kühlmittel, wie zum Beispiel Kraftstoff, Wasser, Motoröl und dergleichen ist ungünstig, zum einen wegen der Gefahr eines Kurzschlusses durch den auch im Kraftstoff und im Motoröl enthaltenen Wasseranteils und zum anderen wegen der Verteuerung des Aktormoduls aufgrund aufwendiger Abdichtungen, die ein Austreten des verwendeten Kühlmittels, insbesondere bei Erwärmung des Aktors aus dem Aktormodul ausschliessen müssen.

Bei dem aus der US 5, 148, 077 bekannten Piezoaktor wird deshalb ein die gemeinsamen Elektrodenanschlüsse beinhaltender Zwischenraum mit Elastomer gefüllt, welches wärmeleitfähige Zusatzteile enthält.

### Aufgaben und Vorteile der Erfindung

Es ist deshalb Aufgabe der Erfindung, einen gattungsgemäßen piezoelektrischen Aktor so zu ermöglichen, daß eine sichere Kühlung des durch den Betrieb sich erwärmenden Aktorkörpers möglich ist, daß der piezoelektrische Aktor einfach montiert werden kann und keine besonderen Abdichtungen, wie bei einer Flüssigkeitskühlung benötigt.

Diese Aufgabe wird gemäß einem wesentlichen Aspekt der Erfindung dadurch gelöst, daß der am Aktorkörper anliegende Abschnitt der Elektrodenanschlüsse eine in den Zwischenraum ragende Verlängerung oder Vergrößerung zur Wärmeableitung vom Aktorkörper aufweist

Bei einer Ausführung sind die verlängerten Abschnitte der gemeinsamen Elektrodenanschlüsse in Form von zu den Seitenwänden des Aktorkörpers parallel liegenden wellenförmigen Bändern oder Folien gestaltet.

Bei einem weiteren Ausführungsbeispiel sind zur Schaffung einer größeren wärmeableitenden Oberfläche die außenliegenden gemeinsamen Elektrodenanschlüsse dadurch verlängert, daß die Elektrodenanschlüsse im Zwischenraum zwischen dem Aktorkörper und der Modulwand einfach oder mehrfach gefaltet sind.

Wenn, wie bevorzugt, ein wellenförmiges Band für die gemeinsamen Elektrodenanschlüsse Verwendung findet, kann die Kühlfläche auch durch Gestaltung der Wellenhöhe vergrößert werden.

Die Weiterleitung der von den vergrößerten oder verlängerten gemeinsamen Elektrodenanschlüssen abgegebenen Wärme zur Modulwand erfolgt bevorzugt durch ein den Zwischenraum ausfüllendes und die verlängerten gemeinsamen Elektrodenanschlüsse umhüllendes wärmeleitfähiges Elastomer.

Eine weitere Steigerung der Kühlwirkung der vergrößerten oder verlängerten gemeinsamen Elektrodenanschlüsse erfolgt durch Benutzung eines Elastomers mit elektrisch leitfähigen Partikeln und hohem Füllungsgrad. In diesem Fall muß die Innenseite der Modulwand elektrisch isoliert werden, zum Beispiel durch eine Lack oder -Oxidschicht.

Außerdem kommt zur Vergrößerung der wärmeableitenden Oberfläche der gemeinsamen Elektrodenanschlüsse auch eine Verlängerung der Anschlußdrähte in Betracht. Auch hier läßt sich die Drahtlänge und damit die wärmeabgebende Oberfläche des Anschlußdrahts durch sein Falten innerhalb des Zwischenraums zwischen dem Aktorkörper und der Modulwand steigern.

Ebenso ist eine Kombination einer gegebenenfalls mehrfach gefalteten Verlängerung der gemeinsamen Elektrodenanschlüsse mit je einem verlängerten Anschlußdraht möglich.

Noch günstiger ist die Einführung von Metallsegmenten in den Zwischenraum, die dann mit den beidseitig verlängerten Elektrodenanschlüssen verlötet oder verschweißt sind. Diese Metallsegmente bestehen bevorzugt aus Kupfer und sind an die mit einer elektrischen Isolationsschicht versehene Modulwand angeklebt.

Kostengünstiger aber nicht ganz so wirksam ist die Benutzung eines Metallgewölles oder -geflechtes, das zwischen die gemeinsamen Elektrodenanschlüsse und der auf ihrer Innenseite elektrisch isolierten Modulwand eingebracht und mit einem elastischen Kleber oder Elastomer zur Fixierung getränkt ist.

Bei allen zuvor erwähnten Ausführungsbeispielen des erfindungsgemäßen piezoelektrischen Aktors kann vorteilhafterweise der Zwischenraum durch ein mit wärmeleitfähigen Partikeln versetztes Elastomer ausgefüllt sein.

Ein mit den obigen Merkmalen gestalteter piezoelektrischer Aktor verwendet die zur guten Wärmeableitung verlängerten oder vergrößerten gemeinsamen außenliegenden Elektrodenanschlüsse zur Abfuhr der Wärme aus dem Aktor. Somit werden zur Wärmeableitung ausschließlich feste Körper verwendet, so daß keine bei einer Flüssigkeitskühlung des Aktors eventuell auftretenden Leckageprobleme entstehen können. Durch die Umhüllung des Aktorkörpers mit einem Elastomer oder ähnlichem entsteht keine Gefahr einer Kurzschlußbildung durch Schwitzwasser oder anderen Schmutz.

Der erfindungsgemäße piezoelektrische Aktor läßt sich besonders vorteilhaft für Common-Rail-Diesel-Injektorsysteme und für PDE-Injektorsysteme einsetzen. Auch Benzindirekteinspritzventile sind mit einem solchen piezoelektrischen Aktor vorteilhaft realisierbar.

Nachfolgend werden die obigen und weitere Aufgaben und Vorteile der Erfindung bezugnehmend auf die mehrere Ausführungsbeispiele darstellende Zeichnung näher beschrieben.

### Zeichnungen

- Figur 1A: zeigt schematisch und im Längsschnitt ein prinzipielles Ausführungsbeispiel eines erfindungsgemäßen piezoelektrischen Aktors;
- Figur 1B: als Querschnitt ein weiteres prinzipielles Ausführungsbeispiel eines erfindungsgemäßen piezoelektrischen Aktors;
- Die Figuren 2 bis 9: zeigen unterschiedliche Varianten eines verlängerten und/oder vergrößerten gemeinsamen Elektrodenanschlusses jeweils in Form eines, einen Ausschnitt durch einen piezoelektrischen Aktor gemäß der Erfindung darstellenden Längsschnitts.

### Ausführungsbeispiele

Bei dem in Figur 1A als Teilschnitt in Längsrichtung dargestellten ersten Ausführungsbeispiel eines erfindungsgemäßen piezoelektrischen Aktors ist ein Aktorkörper 1, der die Form eines vielschichtigen Laminats aus aufeinandergeschichteten Lagen piezoelektrischen Materials und dazwischenliegenden metallischen bzw. elektrisch leitenden als Elektroden dienenden Schichten haben kann mit seinen Stirnseiten links und rechts durch zwei (nicht bezeichnete) Federbänder zwischen einem unteren metallischen Aktorfuß 6 und einer oberen am Aktorkopf liegenden, als Trennwand ausgeführten axial beweglichen Platte 4 elastisch vorgespannt. Das Aktormodul ist von einer metallischen Modulwand 2 eingeschlossen. Es ist zu bemerken, daß Figur 1A nur das linke Federband 11 zeigt. Die der Vorspannung dienenden Federbänder können auch durch eine auf die bewegliche Platte 4 drückende Druckfeder ersetzt werden.

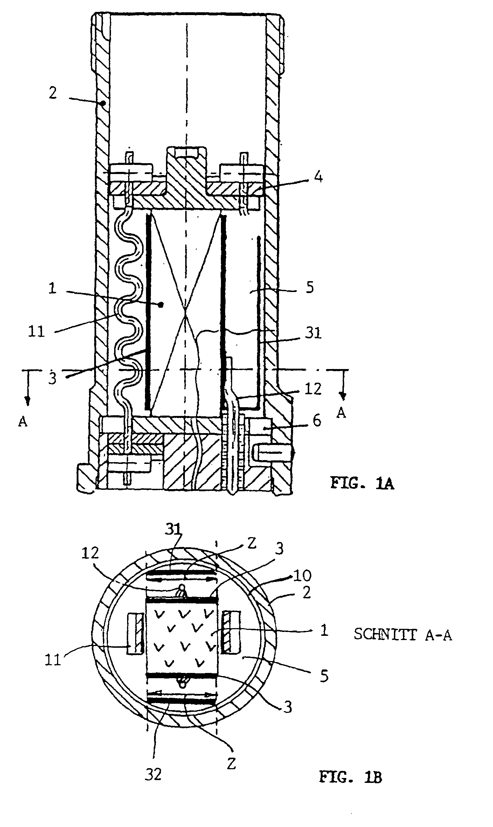

An beiden äußeren Längsseiten des Aktorkörpers 1 in Figur 1B befinden sich gemeinsame leitende Elektrodenanschlüsse 3, die jeweils mit den einzelnen zu dieser Längsseite herausgeführten Elektrodenschichten kontaktiert sind. Wie erwähnt, wird die im Aktorkörper 1 entstehende Wärme überwiegend zu seinen Seitenflächen hingeführt. Dort wird die Wärme von den gemeinsamen Elektrodenanschlüssen 3 aufgenommen und durch deren vergrößerten oder verlängerten Teil an die Umgebung, insbesondere an die Modulwand 2, abgeführt. Die Verlängerungen 31, 32 der gemeinsamen Elektrodenanschlüsse 3 sind U-förmig und ragen parallel zu den Seitenwänden des Aktorkörpers 1 in den Zwischenraum 5 hinein (dargestellt ist zur Vereinfachung nur die rechte Elektrodenverlängerung 31). In der Schnittdarstellung gemäß Figur 1B sind die mit den gemeinsamen Elektrodenanschlüssen 3 in Kontakt stehenden Seitenflächen des Aktorkörpers 1 zu erkennen. Durch Pfeile Z sind die Elektrodenzonen angedeutet. Zu erkennen ist auch eine das Innere der Modulwand 2 elektrisch isolierende Isolierschicht 10, die dafür sorgt, daß die verlängerten Abschnitte 31, 32 der gemeinsamen Elektrodenanschlüsse 3 keinen Kurzschluß an der Modulwand 2 verursachen können. Die Federbänder 11 liegen gemäß Figur 1B längs den Seitenflächen des Aktorkörpers 1, die nicht von den gemeinsamen leitenden Elektrodenanschlüssen 3 bedeckt sind (anders als in der vereinfachten Darstellung in Figur 1A.)

In Figur 1B ist erkennbar, daß beide Elektrodenanschlüsse 3 verlängerte Abschnitte 31, 32 aufweisen.

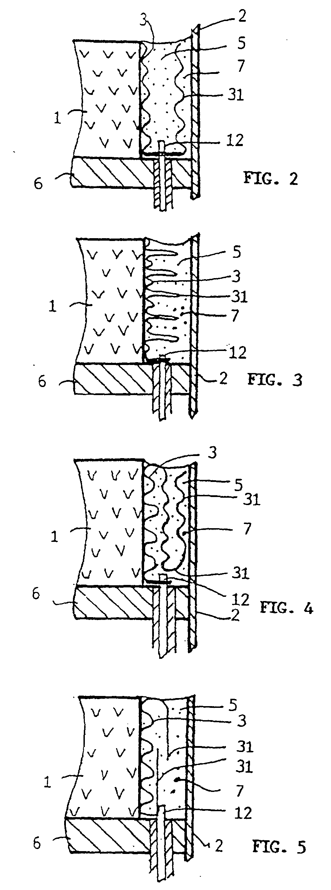

Die in Figur 2 gezeigte Variante unterscheidet sich von der Ausführung in Figur 1 darin, daß ein wellenförmiges Metallband oder eine wellenförmige Metallfolie als gemeinsamer Elektrodenanschluß 3 dient. In diesem Fall besteht der verlängerte Abschnitt 31 des gemeinsamen Elektrodenanschlusses 3 ebenfalls aus einem wellenförmigen Metallband. Weiterhin ist der Zwischenraum 5 mit einem gut wärmeleitenden Elastomer 7 ausgefüllt, welches die von dem verlängerten gemeinsamen Elektrodenanschluß 3, 31 abgegebene Wärme aufnimmt und insbesondere an die metallische Modulwand 2 abgibt. Um die Wärmeleitfähigkeit des Elastomers zu steigern, kann es mit wärmeleitenden Füllstoffen gefüllt sein.

Bei der in Figur 3 dargestellten Variante ist der gemeinsame Elektrodenanschluß 3 dadurch verlängert, daß wenigstens einige der Wellenberge 31 des als gemeinsamer Elektrodenanschluß dienenden Wellenbandes höher sind, wodurch die für die Kühlung effektive Oberfläche des gemeinsamen Elektrodenanschlusses 3 vergrößert ist. Auch bei der in Figur 3 dargestellten Variante kann der Zwischenraum 5 durch ein gut wärmeleitendes Elastomer 7 gegebenenfalls unter Zugabe von wärmeleitenden Füllstoffen ausgefüllt sein.

Bei der in Figur 4 gezeigten Variante ist die Verlängerung 31 des als gemeinsamer Elektrodenanschluß 3 dienenden Wellenbandes innerhalb des Zwischenraums 5 mehrfach gefaltet, so daß im Vergleich mit Figur 2 eine deutlich größere für die Wärmeabfuhr wirksame Oberfläche erreicht ist.

Eine andere Form der Faltung des gemeinsamen Elektrodenanschlusses 3, um dessen für die Wärmeabfuhr effektive Oberfläche zu vergrößern, ist in Figur 5 gezeigt. Dabei sind die beiden, in den Zwischenraum 5 ragenden umgebogenen Endabschnitte 31 des gewellten gemeinsamen Elektrodenanschlusses 3 nicht wellenförmig, sondern verlaufen geradlinig.

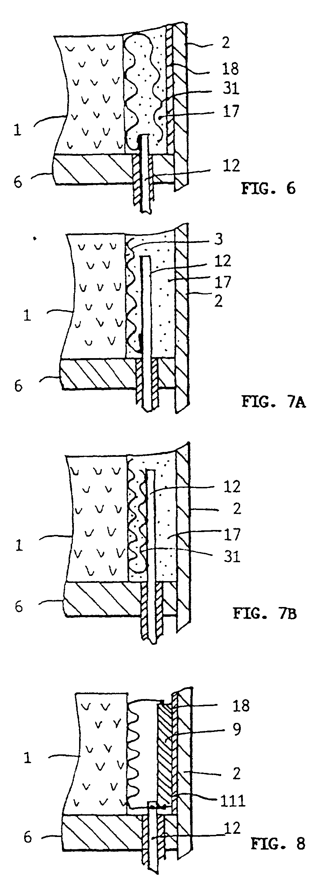

Die in Figur 6 gezeigte Variante besitzt auf der Innenseite der Modulwand 2 eine elektrische Isolationsschicht 18 um zu vermeiden, daß die gegebenenfalls mehrfach gefalteten und wellenförmig verlaufenden Endabschnitte des gemeinsamen Elektrodenanschlusses 3 die Modulwand 2 berühren und daß dem wärmeleitenden Elastomer 7 zugesetzte elektrisch leitende Partikel 17 einen Kurzschluß an der Modulwand 2 verursachen können. Außerdem darf elektrisch leitendes Füllmaterial, wie die Partikel, nicht um den ganzen Aktorkörper 1 laufen, damit eine Kurzschlussgefahr an den beiden gegenüberliegenden Elektroden 3, 31 vermieden ist. Im Gegensatz dazu kann und soll bei allen Lösungsvarianten mit elektrisch isolierenden und gut wärmeleitenden Zusatzteilchen das Elastomer 7 um den ganzen Aktor verlaufen.

Bei der in Figur 7A und 7B gezeigten Variante des erfindungsgemäßen piezoelektrischen Aktors ist der Anschlußdraht 12 in den Zwischenraum 5 hinein verlängert und bildet eine Verlängerung des gemeinsamen Elektrodenanschlusses 3 zur Verbesserung der Wärmeableitung. Die Drahtlänge des Anschlußdrahtes 12 kann durch Falten desselben innerhalb des Zwischenraums 5 noch gesteigert werden.

Die Variante gemäß Figur 7B enthält eine Kombination eines verlängerten Wellenbandes 3 mit einem wie in Figur 7A verlängerten Anschlußdraht 12. Der verlängerte Abschnitt des gemeinsamen Elektrodenanschlusses 3 ist an mehreren Stellen mit dem verlängerten Anschlußdraht 12 kontaktiert.

Noch günstiger ist die in Figur 8 gezeigte Variante, bei der Metallsegmente 9, bevorzugt aus Kupfer in den Zwischenraum 5 eingeführt sind. Ein als gemeinsamer Elektrodenanschluß 3 dienendes Wellenband ist beidseitig mit dem Metallsegment 9 verlötet oder verschweißt. Die Modulwand 2 ist mit einer elektrischen Isolationsschicht 18 versehen, und das Metallsegment 9 wird an die Isolationsschicht 18 mit einem Klebstoff 111 angeklebt.

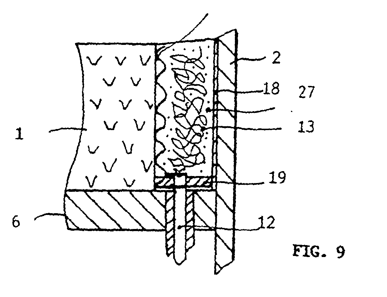

Kostengünstiger aber nicht ganz so wirksam ist die in Figur 9 gezeigte Variante, bei der ein Metallgewölle oder - geflecht 13 zwischen das als gemeinsamer Elektrodenanschluß dienende Wellenband 3 und der elektrisch durch eine Isolationsschicht 18 isolierten Innenseite der Modulwand 2 eingebracht und zur Fixierung mit einem elastischen Kleber oder Elastomer 27 getränkt ist. Der Aktorfuß 6 ist durch eine Elastomerkunstoffscheibe oder Keramikscheibe 19 zum Metallgewölle oder -geflecht 13 hin elektrisch isoliert.

Wie schon erwähnt, können die in den Figuren 2 bis 9 gezeigten Maßnahmen zur Verlängerung oder Vergrößerung des gemeinsamen Elektrodenanschlusses auch miteinander kombiniert werden. Auch kann das Elastomer, gefüllt mit gut wärmeleitfähigem Pulver oder Teilchen, allein schon die Wärmeabfuhr deutlich verbessern und als Lösung dienen.

## Patentansprüche

1. Piezoelektrischer Aktor, insbesondere zur Betätigung von Steuerventilen oder Einspritzventilen an Verbrennungsmotoren in Kraftfahrzeugen mit einem piezoelektrischen Aktorkörper (1) insbesondere in Form eines vielschichtigen Laminats aus aufeinandergeschichteten Lagen piezoelektrischen Materials und dazwischenliegenden metallischen, bzw. elektrisch leitenden, als Elektroden dienenden Schichten, wobei diese Elektrodenschichten durch elektrisch leitende gemeinsame Elektrodenanschlüsse (3, 31, 32) kontaktiert sind und der Aktorkörper (1) unter Einhaltung eines die gemeinsamen Elektrodenanschlüsse beinhaltenden Zwischenraums (5) von einer metallischen Modulwand (2) umgeben ist, wobei die gemeinsamen Elektrodenanschlüsse (3) in Form einer dreidimensional strukturierten Fläche oder eines dreidimensional strukturierten Körpers gestaltet sind, und wobei der Zwischenraum (5) mit Elastomer (7, 17, 27) gefüllt ist, welches wärmeleitfähige Zusatzteile enthält, **dadurch gekennzeichnet, daß** der am Aktorkörper (1) anliegende Abschnitt der Elektrodenanschlüsse (3) eine in den Zwischenraum (5) ragende Verlängerung (31, 32) oder Vergrößerung (9) zur Wärmeableitung vom Aktorkörper (1) aufweist

2. Piezoelektrischer Aktor nach Anspruch 1, **dadurch gekennzeichnet, daß** die gemeinsamen Elektrodenanschlüsse (3) auf zwei einander gegenüberliegenden Seiten des Aktorkörpers (1) vorgesehen sind.

3. Piezoelektrischer Aktor nach Anspruch 1 oder 2, **dadurch gekennzeichnet, daß** die Verlängerung (31, 32) der gemeinsamen Elektrodenanschlüsse (3) in Form eines zu den Seitenwänden des Aktorkörpers parallel liegenden wellenförmigen Bandes oder einer wellenförmigen Folie gestaltet ist bzw. sind.

4. Piezoelektrischer Aktor nach einem der vorangehenden Ansprüche, **dadurch gekennzeichnet, daß** die die Verlängerung (31, 32) der gemeinsamen Elektrodenanschlüsse (3) bildende Folie im Zwischenraum (5) mehrfach gefaltet ist.

5. Piezoelektrischer Aktor nach Anspruch 1, **dadurch gekennzeichnet, daß** die Verlängerung (31, 32) der gemeinsamen Elektrodenanschlüsse (3) durch eine Verlängerung/Vergrößerung der die gemeinsamen Elektrodenanschlüsse kontaktierenden Anschlußdrähte (12) gebildet ist.

6. Piezoelektrischer Aktor nach Anspruch 5, **dadurch gekennzeichnet, daß** jeder verlängerte Anschlußdraht (12) im Zwischenraum (5) mehrfach gefaltet ist.

7. Piezoelektrischer Aktor nach einen der vorangehenden Ansprüche, **dadurch gekennzeichnet, daß** jeweils ein verlängerter, in den Zwischenraum (5) ragender Abschnitt (31, 32) der gemeinsamen Elektrodenanschlüsse (3) an mehreren Stellen seiner Länge mit einem in den Zwischenraum (5) ragenden verlängerten Abschnitt des jeweiligen Anschlußdrahtes (12) kontaktiert sind.

8. Piezoelektrischer Aktor nach Anspruch 1, **dadurch gekennzeichnet, daß** die gemeinsamen Elektrodenanschlüsse (3) jeweils durch ein im Zwischenraum (5) in Längsrichtung des Aktormoduls liegendes Metallsegment (9) vergrößert sind.

9. Piezoelektrischer Aktor nach Anspruch 8, **dadurch gekennzeichnet, daß** jedes Metallsegment (9) durch eine elektrische Isolationsschicht (10) gegenüber der Innenseite der Aktorwand (2) elektrisch isoliert ist.

10. Piezoelektrischer Aktor nach Anspruch 9, **dadurch gekennzeichnet, daß** jedes Metallsegment (9) durch einen Klebstoff (111) auf die Isolationsschicht (10) aufgeklebt ist.

11. Piezoelektrischer Aktor nach Anspruch 1, **dadurch gekennzeichnet, daß** die Vergrößerung oder Verlängerung (31, 32) der gemeinsamen Elektrodenanschlüsse (3) jeweils durch ein Metallgewölle, Metallgeflecht (13) oder dergleichen gebildet ist.

12. Piezoelektrischer Aktor nach einem der vorangehenden Ansprüche, **dadurch gekennzeichnet, daß** der Zwischenraum (5) zwischen dem Aktorkörper (1) und der Modulwand (2) zusätzlich durch ein wärmeleitendes Elastomer (7, 27) ausgefüllt ist.

13. Piezoelektrischer Aktor nach Anspruch 12, **dadurch gekennzeichnet, daß** das wärmeleitende Elastomer (7) mit elektrisch leitfähigen Partikeln (17) ausgefüllt ist.

14. Piezoelektrischer Aktor nach Anspruch 13, **dadurch gekennzeichnet, daß** die Innenseite der Modulwand (2) durch eine elektrisch isolierende Schicht (18) elektrisch isoliert ist.

## Claims

1. Piezoelectric actuator, in particular for the actuation of control valves or injection valves on internal combustion engines in motor vehicles, with a piezoelectric actuator body (1), in particular in the form of a multi-layer laminate consisting of plies of piezoelectric material which are layered one on the other and of metallic or electrically conductive layers lying between them and serving as electrodes, these electrode layers being contacted by electrically conductive common electrode connections (3, 31, 32), and the actuator body (1) being surrounded by a metallic module wall (2) so as to maintain an interspace (5) containing the common electrode connections, the common electrode connections (3) being configured in the form of a three-dimensionally structured surface or of a three-dimensionally structured body, and the interspace (5) being filled with elastomer (7, 17, 27) which contains thermally conductive additives, **characterized in that** the portion of the electrode connections (3) which bears on the actuator body (1) has, projecting into the interspace (5), a prolongation (31, 32) or enlargement (9) for the dissipation of heat from the actuator body (1).

2. Piezoelectric actuator according to Claim 1, **characterized in that** the common electrode connections (3) are provided on two sides of the actuator body (1) which are located opposite one another.

3. Piezoelectric actuator according to Claim 1 or 2, **characterized in that** the prolongation (31, 32) of the common electrode connections (3) is configured in the form of a wavy band or wavy foil lying parallel to the side walls of the actuator body.

4. Piezoelectric actuator according to one of the preceding claims, **characterized in that** the foil forming the prolongation (31, 32) of the common electrode connections (3) is multiply folded in the interspace (5).

5. Piezoelectric actuator according to Claim 1, **characterized in that** the prolongation (31, 32) of the common electrode connections (3) is formed by a prolongation/enlargement of the connecting wires (12) contacting the common electrode connections.

6. Piezoelectric actuator according to Claim 5, **characterized in that** each prolonged connecting wire (12) is multiply folded in the interspace (5).

7. Piezoelectric actuator according to one of the preceding claims, **characterized in that** in each case a prolonged portion (31, 32) of the common electrode connections (3) which projects into the interspace (5) is contacted at a plurality of points along its length by a prolonged portion, projecting into the interspace (5), of the respective connecting wire (12).

8. Piezoelectric actuator according to Claim 1, **characterized in that** the common electrode connections (3) are enlarged in each case by means of a metal segment (9) lying in the interspace (5) in the longitudinal direction of the actuator module.

9. Piezoelectric actuator according to Claim 8, **characterized in that** each metal segment (9) is electrically insulated with respect to the inside of the actuator wall (2) by means of an electrical insulation layer (10).

10. Piezoelectric actuator according to Claim 9, **characterized in that** each metal segment (9) is stuck to the insulation layer (10) by means of an adhesive (111).

11. Piezoelectric actuator according to Claim 1, **characterized in that** the enlargement or prolongation (31, 32) of 'the common electrode connections (3) is formed in each case by a metal wool, metal netting (13) or the like.

12. Piezoelectric actuator according to one of the preceding claims, **characterized in that** the interspace (5) between the actuator body (1) and the module wall (2) is filled additionally with a thermally conductive elastomer (7, 27).

13. Piezoelectric actuator according to Claim 12, **characterized in that** the thermally conductive elastomer (7) is filled with electrically conductive particles (17).

14. Piezoelectric actuator according to Claim 13, **characterized in that** the inside of the module wall (2) is electrically insulated by means of an electrically insulating layer (18).

## Revendications

1. Actionneur piézoélectrique, pour commander notamment des soupapes de distribution ou des injecteurs dans des moteurs à combustion interne de véhicules automobiles, présentant un corps de commande piézoélectrique (1) notamment en forme d'un aggloméré stratifié multi-couche fabriqué à partir de couches superposées de matériau piézoélectrique entre lesquelles on dispose des couches métalliques ou conductrices servant d'électrodes, ces couches d'électrode étant connectées par un ensemble de connexions d'électrodes (3, 31, 32) conductrices, le corps de commande (1) étant, à l'exception de l'intervalle (5) comprenant l'ensemble des connexions d'électrodes, entouré par une paroi de module d'actionneur (2) métallique, l'ensemble des connexions d'électrodes (3) prenant la forme d'une surface structurée en trois dimensions ou d'un corps structuré en trois dimensions et l'intervalle (5) étant rempli d'élastomère (7, 17, 27) contenant des adjuvants thermo-conducteurs,
**caractérisé en ce que**
la partie des connexions d'électrodes (3) reposant contre le corps de commande (1) présente un prolongement (31, 32) ou un élargissement (9) faisant saillie dans l'intervalle (5) pour dissiper la chaleur du corps de commande (1).

2. Actionneur piézoélectrique selon la revendication 1,
**caractérisé en ce que**
toutes les connexions d'électrodes (3) sont prévues sur deux faces du corps de commande (1) se faisant face.

3. Actionneur piézoélectrique selon la revendication 1 ou 2,
**caractérisé en ce que**
le prolongement (31, 32) de toutes les connexions d'électrodes (3) prend la forme d'une bande ondulée ou d'un film ondulé, parallèle aux parois latérales du corps de commande.

4. Actionneur piézoélectrique selon l'une quelconque des revendications précédentes,
**caractérisé en ce que**
le prolongement (31, 32) du film formant l'ensemble des connexions d'électrodes (3) comprises dans l'intervalle (5) est plusieurs fois plié.

5. Actionneur piézoélectrique selon la revendication 1,
**caractérisé en ce que**
le prolongement (31, 32) de l'ensemble des connexions d'électrodes (3) est formé par un prolongement/élargissement des fils de connexion (12) connectant l'ensemble des connexions d'électrodes.

6. Actionneur piézoélectrique selon la revendication 5,
**caractérisé en ce que**
chaque fil de connexion (12) allongé est plié plusieurs fois dans l'intervalle (5).

7. Actionneur piézoélectrique selon l'une quelconque des revendications précédentes,
**caractérisé en ce qu'**
à chaque fois, une partie (31, 32) de l'ensemble des connexions d'électrodes (3) allongées et faisant saillie dans l'intervalle (5) est connectée en plusieurs points de sa longueur à une partie allongée et faisant saillie dans l'intervalle (5) du fil de connexion (12).

8. Actionneur piézoélectrique selon la revendication 1,
**caractérisé en ce**
**qu'**à chaque fois, toutes les connexions d'électrodes (3) sont élargies, dans l'intervalle (5), par un segment métallique (9) placé dans le sens de la longueur du module d'actionneur.

9. Actionneur piézoélectrique selon la revendication 8,
**caractérisé en ce que**
chaque segment métallique (9) est isolé électriquement de la face intérieure de la paroi de module(2) d'actionneur par une couche isolante (10) électrique.

10. Actionneur piézoélectrique selon la revendication 9,
**caractérisé en ce que**
chaque segment métallique (9) est collé sur la couche isolante (10) à l'aide d'une substance adhésive (111).

11. Actionneur piézoélectrique selon la revendication 1,
**caractérisé en ce que**
l'élargissement ou le prolongement (31, 32) de toutes les connexions d'électrodes (3) est à chaque fois formé par une bobine métallique, un treillis métallique (13) ou tout autre structure équivalente.

12. Actionneur piézoélectrique selon l'une quelconque des revendications précédentes,
**caractérisé en ce que**
l'intervalle (5) existant entre le corps de commande (1) et la paroi de module (2) est en outre rempli par un élastomère (7, 27) thermo-conducteur.

13. Actionneur piézoélectrique selon la revendication 12,
**caractérisé en ce que**
l'élastomère (7) thermo-conducteur est rempli de particules (17) conductrices.

14. Actionneur piézoélectrique selon la revendication 13,
**caractérisé en ce que**
la face intérieure de la paroi de module (2) modulaire est isolée électriquement par une couche (18) électriquement isolante.
